# DEMANDE DE BREVET EUROPEEN

(11) **EP 1 727 415 A1**
(43) Date de publication de la demande: **29.11.2006**
(21) Numéro de dépôt: 05291163.3
(22) Date de dépôt: 27.05.2005
(51) Int. Cl.: H05K 13/08

(54) **Système et procédé de détection de trous d'invalidation dans des modules électroniques**

(71) Demandeur: Axalto SA, 92120 Montrouge (FR)
(72) Inventeur: Ros, Frédéric C/o Axalto SA, 92120 Montrouge (FR); Chardon, Joseph C/o Axalto SA, 92120 Montrouge (FR); Michenet, Sébastien C/o Axalto SA, 92120 Montrouge (FR); De Brito Gonzalez, Maria C/o Axalto SA, 92120 Montrouge (FR)
(74) Mandataire: Cassagne, Philippe M.J.

(57) **Abrégé**

L'invention consiste à proposer un système de détection de trous d'invalidation pratiqués dans des modules électroniques d'une bande microélectronique, qui permet de détecter de manière fiable et automatique des trous d'invalidation dans les modules d'une bande microélectronique, quelle que soit la position de ces trous dans les modules, quelle que soit la géométrie de la bande manipulée et, ne nécessitant aucun réglage manuel préalable. Ce système comprend :
- un support de bande (10),
- un banc de rétro-éclairage (11) de la bande,
- une caméra (13) équipée d'un capteur (15) photosensible à transfert de charge et disposée de sorte qu'elle visualise la surface totale d'au moins un module (21) ainsi que les index de référence placés le long des bords longitudinaux de la bande,
- un miroir (16) renvoyant l'image de la bande éclairée vers la caméra,
- un convertisseur apte à convertir des courants électriques produit par le capteur en données numériques, et
- des moyens (17) pour diagnostiquer, à partir desdites données numériques, la présence d'un trou d'invalidation dans chaque module visualisé, et pour calculer les dimensions dudit trou.

## Description

La présente invention concerne un système et un procédé de détection de trous d'invalidation pratiqués dans des modules électroniques.

L'invention se situe dans le domaine de la fabrication des cartes à puces. Elle vise les étapes de fabrication liées à la manipulation des bandes microélectroniques avant le report des modules électroniques dans les cartes et leur encartage. Elle vise plus particulièrement la détection de trous d'invalidation pratiqués dans des modules considérés comme défectueux afin de ne pas les reporter dans les cartes.

Un procédé classique pour invalider les modules électroniques pour la suite des étapes de fabrication des cartes à puce consiste à faire un trou dans ces modules. Ainsi, au moment de l'encartage d'un module, si la machine dédiée à cette étape d'encartage détecte la présence d'un trou d'invalidation dans ce module, elle ne traite pas ce module puisqu'il est alors considéré comme défectueux.

Les machines traditionnelles de manipulation des bandes de micromodules, en vue de l'encartage des micromodules, sont classiquement munies de capteurs capables de détecter des trous d'invalidation, de gérer correctement un défaut d'alignement des bandes, et de détecter des fins de bandes. Classiquement, elles comportent quatre cellules de détection : une cellule est dédiée à la détection de trous dans chaque module disposé côte à côte dans la largeur de la bande microélectronique, une autre cellule est dédiée à la détection de la présence d'un index de référence afin de gérer les défauts d'alignement, et une cellule est dédiée à la signalisation d'une fin de bande. Ces machines permettent de détecter des trous d'invalidation de manière très fiable, à condition que les cellules de détection soient bien positionnées en face de la position présumée des trous. Or, d'une bande à l'autre, la position des trous peut varier, de par la géométrie des bandes qui change selon le fabricant par exemple, ou de par la machine utilisée pour pratiquer les trous. Par conséquent, pour chaque machine d'encartage, il faut réaliser un réglage manuel de la position des cellules préalablement à toute opération de détection des trous d'invalidation.

En outre, il a été constaté que la position des trous d'invalidation peut également varier dans une même bande, essentiellement du fait qu'un décalage non géré par rapport aux index de référence peut se produire, mais aussi parce que la précédente machine ayant réalisé les trous d'invalidation a réalisé ces trous à des positions différentes. Même si une normalisation est de fait, des erreurs de ce type ont été constatées encore récemment. Dans ce cas, la fiabilité de la détection par les cellules est réduite et devient même inefficace. Les conséquences sont lourdes puisque la fabrication de cartes défectueuses engendre de lourdes pertes financières et aussi des réclamations de clients mécontents. Par conséquent, pour une même machine d'encartage, il faut parfois refaire un réglage de la position des cellules de détection au cours de la détection des trous dans des modules d'une même bande, ce qui implique l'arrêt de la machine pendant toute la durée du réglage, et donc une réduction considérable de la cadence de traitement des modules.

La position des cellules de détection doit donc être réglée préalablement à toute opération de détection de trous d'invalidation. Cette opération de réglage des cellules est réalisée manuellement. Or, on sait que tout réglage manuel est fastidieux et peut avoir de très graves conséquences sur la production. En effet, l'opérateur peut avoir fait un mauvais réglage, voire même il peut avoir oublié de faire le réglage préalable, si bien que des modules défectueux ne sont alors pas détectés par la machine d'encartage et sont reportés dans des cartes. De plus, un bon réglage manuel est long à mettre en place et constitue également une perte de temps non négligeable dans le procédé de fabrication des cartes.

Enfin, certaines machines ne permettent pas de faire des réglages et sont donc totalement inefficaces dès lors que l'on ne se trouve plus dans une configuration standard.

Aussi, le problème technique objet de la présente invention consiste à proposer un système détection de trous d'invalidation pratiqués dans des modules électroniques d'une bande microélectronique, qui permettrait de détecter de manière fiable et automatique des trous d'invalidation dans les modules d'une bande microélectronique, quelle que soit la position de ces trous dans les modules, quelle que soit la géométrie de la bande manipulée, ne nécessitant aucun réglage manuel préalable, et qui serait suffisamment compact pour pouvoir être intégré dans n'importe quelle machine de manipulation de bandes existante.

La solution au problème technique posé est obtenue, selon la présente invention, par le fait que le système comprend :
- un support de bande,
- un banc de rétro-éclairage de la bande,
- une caméra équipée d'un capteur photosensible à transfert de charge et disposée de sorte qu'elle visualise la surface totale d'au moins un module ainsi que les index de référence placés le long des bords longitudinaux de la bande,
- un miroir renvoyant l'image de la bande éclairée vers la caméra,
- un convertisseur apte à convertir des courants électriques produit par le capteur en données numériques, et
- des moyens pour diagnostiquer, à partir desdites données numériques, la présence d'un trou d'invalidation dans chaque module visualisé, et pour calculer les dimensions de ce trou.

Ainsi, le fait que la caméra visualise toute la surface d'un module ainsi que les index de référence permet de définir une zone d'inspection avec une grande précision, et d'éviter la nécessité d'un réglage manuel préalable. Cette visualisation permet notamment de détecter automatiquement la présence d'un trou d'invalidation quelle que soit sa position dans le module, afin de parer aux changements de position des trous d'invalidation au sein d'une même bande, et d'éviter toute confusion avec des trous présents à proximité du module sans être des trous d'invalidation.

Par ailleurs, la présence du miroir permet d'éviter de positionner la caméra, et le capteur associé, à la verticale des modules à inspecter mais de la positionner en dessous, parallèlement au support de bande, et de réduire ainsi significativement la compacité du système. Ainsi, le système est suffisamment compact pour être intégré dans une machine de manipulation de bandes existante sans nécessiter de la modifier.

Le miroir permet ainsi de renvoyer la lumière traversant les index de référence et les trous présents à la surface d'un module vers la caméra et son capteur associé.

L'invention porte également sur un procédé de détection de trous d'invalidation pratiqués dans des modules électroniques d'une bande microélectronique, qui permet de détecter de manière fiable, automatique et rapide des trous d'invalidation pratiqués dans les modules d'une bande microélectronique, quelle que soit la position de ces trous dans les modules, quelle que soit la géométrie de la bande manipulée, et ne nécessitant aucun réglage manuel préalable.

Ce procédé est remarquable en ce qu'il comprend les étapes suivantes :
- apprentissage de la bande, par la définition de zones d'inspection par rapport à des index de référence disposés le long des bords longitudinaux de la bande, chaque zone d'inspection correspondant respectivement à la surface d'un module à analyser, et
- pour chaque zone d'inspection :

- détection de la présence d'une zone lumineuse,
- calcul de la surface de la zone lumineuse détectée,
- comparaison de la surface calculée à une valeur seuil Ss pré-enregistrée,
- classement du module comme défectueux lorsque la surface calculée est supérieure à la valeur seuil.

Il suffit de la présence d'une bande quelconque de géométrie connue pour lancer cette procédure qui se fait de manière automatique et bloque le système en cas d'erreur.

Lors de l'apprentissage d'une bande, les zones d'inspection sont définies par rapport aux index de manière à parer à tout décalage éventuel des modules et à tout défaut d'alignement de la bande. Une zone d'inspection correspondant à la surface totale d'un module, un réglage manuel préalable de la position de la caméra n'est pas nécessaire. Les points lumineux détectés par le capteur CCD sont qualifiés de trous d'invalidation lorsque leur dimension est supérieure à une valeur seuil pré-définie.

De plus, un calibrage préalable de la caméra permet de modéliser avec une grande précision la géométrie du champ de la caméra.

Selon une autre caractéristique avantageuse, la détection de la zone lumineuse est réalisée par décomposition de la zone d'inspection en zones élémentaires, et le calcul de la surface de la zone lumineuse est réalisé par sommation de la surface de tous les points lumineux connexes détectés appartenant à au moins deux zones élémentaires adjacentes.

Le procédé possède en outre une fonction d'alerte pour prévenir d'une défaillance éventuelle du système provenant essentiellement d'une baisse d'intensité du banc de rétro-éclairage mais aussi la présence trop importante de poussières sur le miroir réflectif. Cette fonction d'alerte permet de mettre en oeuvre une étape supplémentaire qui consiste à mesurer le contraste de la zone élémentaire visualisée, à comparer le contraste mesuré à un contraste minimal requis, à adapter la valeur de la puissance seuil de détection de chaque point lumineux de la zone élémentaire visualisée tant que le contraste mesuré est supérieur au contraste minimal requis, et à arrêter le procédé de détection dès que le contraste mesuré est inférieur au contraste minimal requis.

D'autres particularités et avantages de l'invention apparaîtront à la lecture de la description suivante faite à titre d'exemple illustratif et non limitatif, en référence aux figures annexées qui représentent :
- la figure 1, une vue schématique de côté d'un système selon l'invention,
- la figure 2, une image de deux modules, disposés côte à côte dans la largeur d'une bande microélectronique, vus par une caméra d'un système selon l'invention,
- la figure 3, un organigramme des étapes d'un procédé selon l'invention, et
- la figure 4, un schéma illustrant une manière de paramétrer la géométrie d'une bande quelconque.

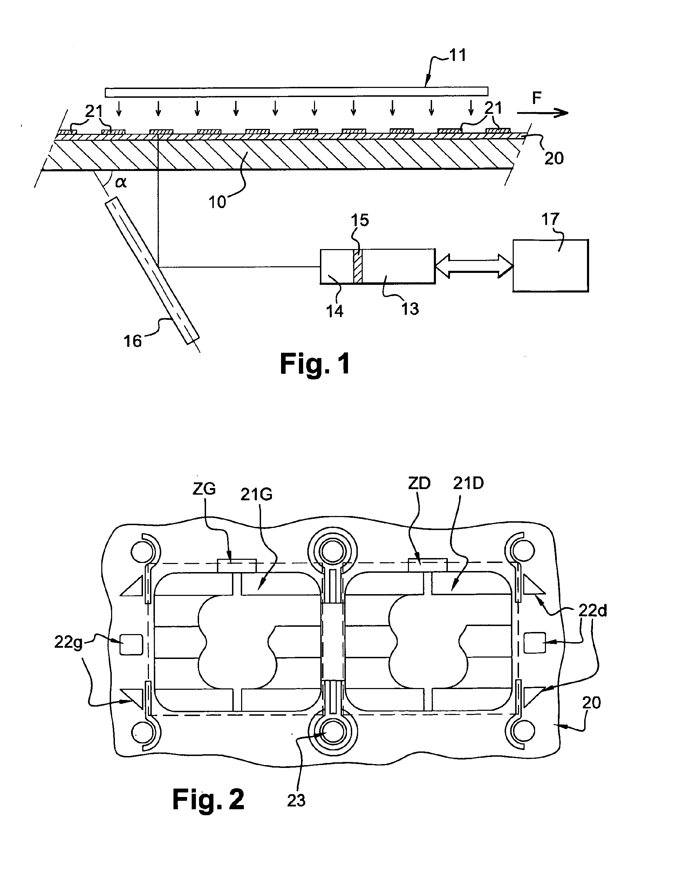

Le système selon l'invention, tel qu'illustré sur la figure 1, comporte un support de bande 10 transparent, par exemple une plaque de plexiglas, pour permettre de laisser passer des faisceaux de lumière. Ce support de bande 10 est rétro-éclairé par des moyens de rétro-éclairage 11, également connus sous le nom « back light ». Ces moyens de rétro-éclairage sont par exemple constitués par un banc de diodes électroluminescentes plates. La bande microélectronique 20 supportant les modules 21 à inspecter défile pas à pas sur le support de bande 10 dans le sens de la flèche F par exemple. Une caméra 13, munie d'un objectif 14 est positionnée sous le support de bande, parallèlement à ce-dernier. La caméra comporte un capteur photosensible à transfert de charge ou capteur CCD 15. Ce capteur délivre un signal matriciel de capture. En outre, ce capteur est de basse résolution en comparaison notamment des capteurs commercialisés avec des appareils photos numériques de dernière génération. Un capteur basse résolution suffit en effet pour détecter la présence d'un trou d'invalidation à la surface d'un module. La caméra visualise globalement la surface d'au moins un module ainsi que les index de référence disposés sur les bords longitudinaux de la bande 20.

Un miroir 16 est placé de manière à réfléchir vers la caméra 13 la lumière traversant les index, référencés 22g et 22d sur la figure 2, et les trous présents dans les modules. L'angle α que fait le miroir 16 par rapport au support de bande 10 est compris entre 30° et 50°. Il est de préférence de l'ordre de 45° pour renvoyer une image non déformée vers la caméra. Selon l'invention, l'objectif 14 de la caméra est orienté de manière que le capteur 15 de la caméra 13 capte la lumière reçue via le miroir 16.

Le capteur CCD 15 génère des courants électriques en fonction de la lumière reçue. Ces courants électriques sont convertis en données numériques par un convertisseur non représenté sur la figure 1 et qui peut être intégré dans la caméra.

En outre, le système selon l'invention comporte des moyens pour détecter, à partir des données numériques générées par le convertisseur, la présence ou non d'un trou d'invalidation dans un module, quelle que soit la position de ce trou dans le module. Ces moyens permettent aussi de calculer les dimensions d'un trou détecté. Ils sont par exemple formés par un ordinateur 17 connecté à la caméra 13. Cet ordinateur implémente avantageusement un algorithme de détection de trous d'invalidation qui permet d'obtenir, sans aucune intervention de l'utilisateur, la représentation exacte d'un trou d'invalidation et ce, dans le repère du capteur 15 correspondant.

Après avoir diagnostiqué la présence d'un trou d'invalidation et avoir calculé ses dimensions, le système envoie, par le biais de moyens de communication non représentés sur la figure 1, les données issues des résultats de son diagnostic à un système hôte de la machine de manipulation de bandes dans laquelle il est intégré. Le système hôte de la machine de manipulation de bandes constitue le coeur de la machine, il se compose d'un ordinateur ou d'un automate ou de tout autre composant intelligent.

Le moyen de communication permettant de relier le système de détection de trous d'invalidation au système hôte de la machine de manipulation des bandes peut se présenter soit sous une forme filaire, tel qu'un bus de communication par exemple, soit sous forme sans fil, tel qu'un moyen de communication infra-rouge ou un moyen de communication par fréquence radio par exemple.

Le système comporte en outre une unité d'alerte, non représentée sur la figure 1, qui peut être reliée aux moyens 17 de diagnostic et de calculs ou être intégrée dans ces moyens. Cette unité d'alerte a pour fonction de contrôler une dérive trop importante de la puissance lumineuse transmise et pouvant affecter le diagnostic. En effet, lorsque le banc de rétro-éclairage est en phase de vieillissement ou lorsque de la poussière s'est accumulée sur le miroir 16 par exemple, la transmission de la puissance lumineuse est réduite. Par conséquent, l'unité d'alerte vérifie que le contraste visualisé est acceptable, sur la base d'un différentiel entre une puissance lumineuse pré-enregistrée et une puissance lumineuse mesurée. Lorsque le contraste mesuré est inférieur au contraste minimal requis, l'unité d'alerte bloque le système qui se met en alarme puis s'arrête.

Un exemple d'image visualisée par la caméra est illustré sur la figure 2. Dans cet exemple, la caméra visualise la surface de deux modules 21G et 21D, placés côte à côte dans le sens de la largeur de la bande 20, ainsi que les index de référence gauche 22g, et droite 22d, disposés de part et d'autre le long des bords longitudinaux de la bande. L'utilisation d'un capteur CCD permet d'inspecter la surface totale de chaque module et de parer à des positions différentes des trous de manière automatique. Le fait d'avoir une vue globale d'un module 21G, 21D ainsi que des index de référence 22g, 22d permet de définir avec une grande précision des zones d'inspection ZG, ZD évitant ainsi une confusion avec d'autres trous 23 présents dans la bande, à proximité des modules, sans être des trous d'invalidation. C'est le cas pour les trous 23 servant par exemple à la fixation ultérieure du module sur une couche intermédiaire par dispense d'une colle dans le trou ou pour tout autre besoin de repérage. Sur l'exemple de la figure 2, la forme des zones d'inspection ZG, ZD est par exemple rectangulaire avec la possibilité de rogner les coins en quart de cercle. Cependant, toute autre géométrie est possible sans sortir du cadre de l'invention.

La géométrie de chaque type de bande est stockée dans une base de données pour permettre le passage d'une production à l'autre de manière instantanée.

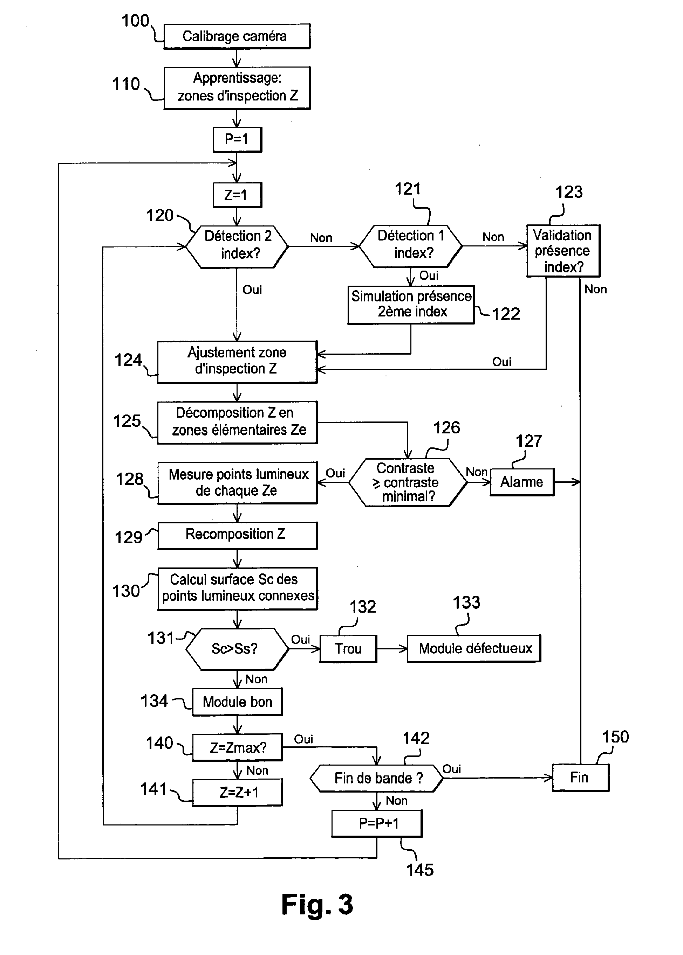

Le système qui vient d'être décrit permet de mettre en oeuvre un procédé de détection de trous d'invalidation dont les principales étapes sont schématisées sur l'organigramme de la figure 3.

Une première étape 100 consiste à calibrer la caméra, c'est à dire à modéliser la géométrie du champ de la caméra. Cette modélisation permet ensuite, au moyen d'algorithmes dédiés, de détecter rapidement la présence ou non de trous d'invalidation. Pour cela, une bande microélectronique de géométrie connue, avec une localisation connue des index de référence, est placée sur le support de bande 10 et son défilement pas à pas est actionné. La géométrie du champ de la caméra est ensuite modélisée pour obtenir exactement la géométrie de cette bande étalon. Lorsque le calibrage est terminé, il est validé et les opérations de test des différents module d'une bande quelconque à analyser peut commencer. Cette étape de calibrage n'est réalisée que très rarement, au moment de la mise en place du système de détection de trous dans une machine de manipulation de bandes, ou au moment d'opérations de maintenance par exemple.

L'étape suivante 110 consiste à placer une bande quelconque à inspecter sur le support de bande, puis à réaliser un apprentissage de cette bande. Cette étape d'apprentissage consiste en fait à définir d'une part des zones contenant les index de référence et d'autre part des zones d'inspection correspondant chacune à la surface d'un module. En fait, la définition des zones d'inspection ne peut se faire que par rapport à l'emplacement des index de référence. Il est donc important de bien définir les zones contenant les index de référence. L'étape d'apprentissage doit être réalisée pour chaque nouvelle bande à analyser.

La définition des différentes zones d'inspection et des zones d'index est effectuée à partir de la géométrie de la bande ayant été préalablement paramétrée. De préférence, une fois que la géométrie d'une bande a été paramétrée, ses paramètres sont stockés dans une base de données, de manière à ne plus avoir qu'à modifier certains paramètres lorsqu'une bande similaire doit être manipulée.

La géométrie de tout type de bande peut être paramétrée ainsi que la taille minimale des trous d'invalidation par exemple, en fonction des paramètres qualité du client, des machines ayant réalisé les trous d'invalidation, etc... Ainsi, lorsqu'un opérateur doit inspecter une bande, il peut rechercher dans la base de données les paramètres de la bande correspondante et modifier certains d'entre-eux, comme par exemple la taille des trous d'invalidation à détecter, ou la position et la taille des index de référence etc..., et définir les zones d'inspection en fonction de ces paramètres.

La détection des trous d'invalidation dans chaque zone d'inspection Z préalablement définie peut alors commencer, au cours du défilement pas à pas P de la bande. Dans ce cas, on dit que le système passe en mode production ou encore automatique, c'est-à-dire qu'il attend l'ordre de traiter un module puis, après avoir effectué le traitement il renvoie un diagnostic avant de se remettre en attente.

Dans un premier temps (étape 120), le capteur CCD associé à la caméra doit détecter la présence des index de référence symétriques, situés de part et d'autre des modules à inspecter, le long des bords longitudinaux de la bande. Si le capteur ne détecte pas les deux index disposés de manière symétrique, un test est effectué pour savoir si il en détecte au moins un (étape 121).

Si le capteur ne détecte qu'un seul index sur les deux (étape 121), cela signifie que le deuxième index non détecté est bouché complètement ou partiellement. Dans ce cas, la machine est capable de simuler la présence du deuxième index à partir des paramètres pré-enregistrés de la bande sous inspection (étape 122).

Si le capteur ne détecte aucun index, cela signifie par exemple qu'il n'y a pas de bande ou qu'un autre problème est apparu comme par exemple le bouchage des deux index provenant d'un raccord adhésif imparfait entre deux morceaux de bande. Dans ce cas, une procédure particulière (étape 123) consiste à vérifier qu'aux centres des positions théoriques des index, l'intensité lumineuse sur une surface de l'ordre de 1mm² est telle que la présence des index peut être validée. Les positions théoriques des index sont connues grâce aux paramètres pré-enregistrés. Cette étape de vérification n'a pas la précision de la détection des trous d'index car le contour réel des index n'est pas déterminé. Elle ne peut mesurer qu'un décalage inférieur de la moitié d'un index. Toutefois, la probabilité d'avoir à la fois un décalage de bande et un raccord bouchant les deux trous d'index est très faible sur le même module et proche de zéro. En effet, un décalage de bande est généralement important mais surtout, n'est pas ponctuel donc aisément détecté auparavant par le système.

Une fois que les index de référence sont détectés ou simulés, il est possible de déterminer les décalages éventuels de la position des index, de recalculer et d'ajuster la position des zones d'inspection à analyser (étape 124). Chaque zone d'inspection à analyser est ensuite décomposée en zones élémentaires Ze (étape 125). Un tel quadrillage de la zone d'inspection permet de raccourcir le temps de traitement des analyses car la présence d'un trou d'invalidation est ensuite déterminée par déduction, lorsque plusieurs zones élémentaires adjacentes présentent des défauts connexes. Ce quadrillage permet aussi d'éliminer la présence de « bruit » dont la surface cumulée sur toute l'image d'une zone d'inspection pourrait être confondue avec un trou d'invalidation.

Dans ce cas, seuls les défauts connexes sont traités, c'est-à-dire que la surface des différents défauts connexes est sommée afin de déterminer si, lorsqu'ils sont regroupés, ils constituent un trou d'invalidation.

La puissance lumineuse de la lumière traversant les index de référence et mesurée par le capteur CCD et parfaitement connue. Par conséquent, la machine est en mesure de déterminer qu'à partir d'un certain seuil de puissance lumineuse traversant chaque zone élémentaire on est en présence d'un point lumineux. Ce seuil a un double rôle. Il permet d'une part de s'adapter à une dérive de puissance lumineuse en ajustant la valeur du seuil de détection du point lumineux et d'autre part, de contrôler une dérive trop importante pouvant affecter la qualité du diagnostic. Une telle dérive peut se produire par exemple dans le cas où l'éclairage est en phase de vieillissement ou dans le cas où de la poussière s'accumule sur le miroir et limite la transmission de la puissance lumineuse. Par conséquent, à chaque nouvel apprentissage de bande, le système vérifie que la puissance lumineuse traversant les index est compatible avec l'objectif du système, c'est-à-dire avec un contraste minimal, et la valeur de cette puissance est stockée comme référentiel dans la base de données associée aux paramètres de la bande. Le contraste minimal requis dépend en fait d'un seuil bas Ps d'acceptabilité de la puissance lumineuse qui est également stocké dans cette base de données. Tant que le différentiel entre la puissance lumineuse stockée lors de la phase d'apprentissage et la puissance mesurée pour chaque zone élémentaire reste acceptable au sens du contraste, il y a adaptation (étape 126). Dans le cas contraire, le système se met en alarme (étape 127) puis s'arrête.

Un filtrage local est donc réalisé sur chaque zone élémentaire, et le capteur CCD mesure la dimension de tous les points lumineux détectés (étape 128).

A partir de ces mesures, la zone d'inspection Z est ensuite recomposée (étape 129), les points lumineux connexes appartenant à des zones élémentaires adjacentes sont regroupés, formant une zone lumineuse, et la surface Sc totale de tous ces points lumineux connexes formant une zone lumineuse est calculée (étape 130). La surface calculée Sc de la zone lumineuse est ensuite comparée (étape 131) à une valeur seuil Ss de la surface d'un trou pré-enregistrée dans la base de données de paramétrage.

Si la taille calculée Sc de la zone lumineuse, formée par tous les points lumineux connexes, est supérieure à la valeur seuil Ss, le système en déduit la présence d'un trou d'invalidation (étape 132) et défini le module comme défectueux (étape 133) si bien qu'il ne sera pas reporté dans une carte. Si, en revanche, la taille de la zone lumineuse détectée est inférieure à la valeur seuil Ss, le module est déclaré bon (étape 134) et il sera reporté dans une carte.

Ces informations sur le statut bon ou mauvais du module sont ensuite envoyées vers le système hôte de la machine de manipulation de bandes, via un moyen de communication, pour que la machine de manipulation de bande sache si elle doit reporter ou non le module analysé dans une carte.

L'étape suivante 140 consiste à vérifier que toutes les zones d'inspection définies entre les deux index de référence détectés ont bien été analysées. Si ce n'est pas le cas, la zone non inspectée est analysée (étape 141) selon les étapes 120 à 140 qui viennent d'être décrites, puis la bande est avancée d'un pas P (étape 145), et les étapes 120 à 141 de détection d'index, et de détection de trous sont répétées pour chaque zone d'inspection définie entre des index de référence tout le long de la bande.

A chaque analyse s'adjoint un diagnostic de fin de bande (étape 142). Une fin de bande se caractérise par la présence d'un film plastique blanc ou transparent à la place de la bande de module. Un double critère de texture et de luminosité sur la surface d'inspection permet de garantir le diagnostic de présence ou absence de bande. Dans ce cas, le système de détection de trous renvoie au système hôte de la machine de manipulation de bandes, un diagnostic de fin de bande.

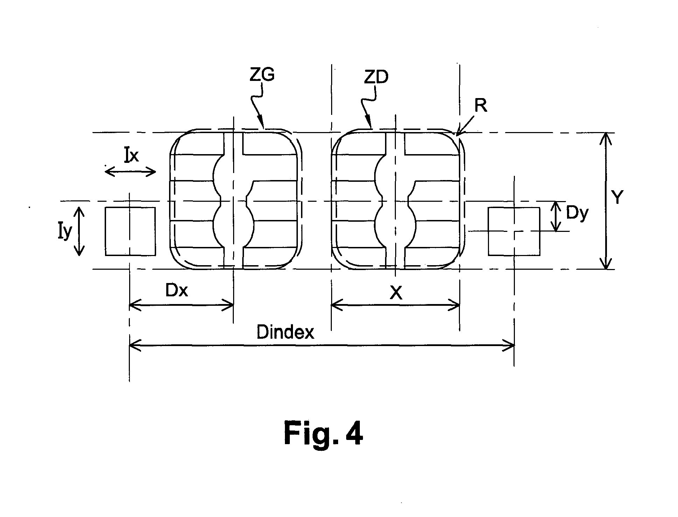

La figure 4 est une représentation schématique de la géométrie d'un type de bande dans une base de données. Les paramètres des bandes de ce type sont définis préalablement à la détection des trous. Ainsi, les paramètres tels que la taille en X et Y, respectivement selon les axes x et y du repère cartésien, des zones d'inspection gauche ZG et droite ZD sont enregistrés, ainsi que le rayon de courbure R des coins des zones d'inspection, la distance Dy selon l'axe y entre le centre des index et celui des zones d'inspection, la distance Dx selon l'axe x entre le centre d'un index et celui d'une zone d'inspection, la distance Dindex selon l'axe x entre les centres des deux index symétriques, la taille Ix et Iy respectivement selon les axes x et y de chaque index, la valeur permise de décalage en x et en y des index, la valeur seuil de la puissance lumineuse à détecter, la surface minimum d'un trou d'invalidation etc... Bien sûr, les paramètres qui viennent d'être cités ne sont pas limités à ceux-ci et d'autres paramètres peuvent être enregistrés.

Les modes de réalisation qui viennent d'être décrits ne sont que des exemples illustratifs auxquels l'invention ne se limite pas. En effet, de multiples variations des modes de réalisation décrits ci-dessus peuvent être envisagées tout en restant dans le cadre large de l'invention.

## Revendications

1. Système de détection de trous d'invalidation pratiqués dans des modules électroniques (21G, 21D) d'une bande microélectronique (20), **caractérisé en ce que** ledit système comprend :
- un support de bande (10),
- un banc de rétro-éclairage (11) de la bande,
- une caméra (13) équipée d'un capteur (15) photosensible à transfert de charge et disposée de sorte qu'elle visualise la surface totale d'au moins un module (21G, 21D) ainsi que les index de référence (22g, 22d) placés le long des bords longitudinaux de la bande (20),
- un miroir (16) renvoyant l'image de la bande éclairée vers la caméra (13),
- un convertisseur apte à convertir des courants électriques produits par le capteur (15) en données numériques, et
- des moyens (17) pour diagnostiquer, à partir desdites données numériques, la présence d'un trou d'invalidation dans chaque module visualisé et pour calculer les dimensions dudit trou.

2. Système selon la revendication 1, dans lequel la caméra (13) est disposée parallèlement au support de bande (10).

3. Système selon l'une des revendications 1 ou 2, dans lequel l'angle entre le miroir (16) et le support de bande (10) est compris entre 30° et 50°.

4. Système selon l'une quelconque des revendications 1 à 4, **caractérisé en ce qu'**il comprend en outre une unité d'alerte apte à arrêter le système lorsque le contraste lumineux de la surface visualisée est inférieur à un contraste lumineux minimal requis.

5. Système selon l'une quelconque des revendications 1 à 5, **caractérisé en ce qu'**il est intégré dans une machine de manipulation de bandes microélectroniques.

6. Procédé de détection de trous d'invalidation pratiqués dans des modules électroniques (21G, 21D) d'une bande microélectronique (20), **caractérisé en ce que** ledit procédé comprend les étapes suivantes :
- apprentissage (110) de ladite bande, par la définition de zones d'inspection par rapport à des index de référence disposés le long des bords longitudinaux de la bande, chaque zone d'inspection correspondant respectivement à la surface d'un module à analyser, et
- pour chaque zone d'inspection :
- détection (129) de la présence d'une zone lumineuse,
- calcul (130) de la surface de la zone lumineuse détectée,
- comparaison (131) de la surface calculée à une valeur seuil Ss pré-enregistrée,
- classement (133) du module comme défectueux lorsque la surface calculée est supérieure à la valeur seuil.

7. Procédé selon la revendication 6, **caractérisé en ce qu'**une étape préalable (100) consiste à calibrer la caméra.

8. Procédé selon la revendication 6 ou 7, **caractérisé en ce que** la détection de la zone lumineuse est réalisée par décomposition (125) de la zone d'inspection (Z) en zones élémentaires (Ze).

9. Procédé selon la revendication 8, **caractérisé en ce que** le calcul (130) de la surface de la zone lumineuse est réalisée par sommation de la surface de tous les points lumineux connexes détectés appartenant à au moins deux zones élémentaires (Ze) adjacentes.

10. Procédé selon la revendication 8 ou 9, **caractérisé en ce qu'**il consiste en outre à mesurer le contraste de la zone élémentaire visualisée, à comparer le contraste mesuré à un contraste minimal requis, à adapter la valeur de la puissance seuil de détection de chaque point lumineux de la zone élémentaire visualisée tant que le contraste mesuré est supérieur au contraste minimal requis, et à arrêter le procédé de détection dès que le contraste mesuré est inférieur au contraste minimal requis.

11. Procédé selon l'une quelconque des revendications 6 à 10, **caractérisé en ce qu'**après avoir classé un module, les données relatives à ce classement sont envoyées à un système hôte d'une machine de manipulation de bandes microélectroniques à travers au moins un moyen de communication.
